Europäisches Patentamt

European Patent Office

Office européen des brevets

(19)

(11) Publication number: **0 251 347 B1**

# EUROPEAN PATENT SPECIFICATION

(45) Date of publication of patent specification: **18.03.92**　(51) Int. Cl.5: **H01L 21/312**

(21) Application number: **87200672.1**

(22) Date of filing: **09.04.87**

(54) **Method of covering a device with a first layer of silicon nitride and with a second layer of a polyimide, and device covered by means of the method.**

(30) Priority: **23.04.86 NL 8601041**

(43) Date of publication of application:
**07.01.88 Bulletin 88/01**

(45) Publication of the grant of the patent:
**18.03.92 Bulletin 92/12**

(84) Designated Contracting States:
**DE FR GB IT NL**

(56) References cited:
**EP-A- 0 047 184**
**EP-A- 0 107 240**
**FR-A- 2 324 707**
**US-A- 4 330 569**

**JOURNAL OF THE ELECTROCHEMICAL SOCI-
ETY, vol. 132, no. 11, November 1985, pages
2700-2705, Ohio, US; R.G. NARECHANIA et al.:
""Polyimide adhesion"**

**MACHINE DESIGN, vol. 45, no. 1, 11th Janu-
ary 1973, Cleveland, US; "UV Beam vaporizes
photoresist from semiconductor"**

(73) Proprietor: **N.V. Philips' Gloeilampenfabrieken
Groenewoudseweg 1
NL-5621 BA Eindhoven(NL)**

(72) Inventor: **Ponjée, Johannes Jacobus
c/o INT. OCTROOIBUREAU B.V. Prof. Holst-
laan 6
NL-5656 AA Eindhoven(NL)**
Inventor: **Gootzen, Wilhelmus Franciscus Ma-
rie
c/o INT. OCTROOIBUREAU B.V. Prof. Holst-
laan 6
NL-5656 AA Eindhoven(NL)**
Inventor: **Touwslager, Fredericus Johannes
c/o INT. OCTROOIBUREAU B.V. Prof. Holst-
laan 6
NL-5656 AA Eindhoven(NL)**

(74) Representative: **Weening, Cornelis et al
INTERNATIONAAL OCTROOIBUREAU B.V.
Prof. Holstlaan 6
NL-5656 AA Eindhoven(NL)**

PATENT ABSTRACTS OF JAPAN, vol. 7, no. 260 (P-237)[1405], 18th November 1983; & JP-A-58 143 340

POLYMER SCIENCE TECHNOLOGY, vol. 27, 1985, pages 187-204; D.J. BELTON et al.: "The effect of gamma-APS substrate modification upon the chemical adhesion of poly(amic acid-imide) films"

TECHNICAL DIGEST OF THE INTERNATIONAL ELECTRON DEVICES MEETING, Washington, DC, 3rd-5th December 1979, pages 465-468, IEEE; P. SHAH et al.: "High performance, high density MOS process using polymide interlevel insulation"

## Description

The invention relates to a method of manufacturing a device at least one surface of which is coated with a first layer of silicon nitride and with a second layer of a polyimide, in which a bonding agent is used at the interface of the two layers.

The method according to the invention is used, for example, for the manufacture of a semiconductor device.

Devices, in particular semiconductor devices, must generally be protected from undesired environmental influences. For this purpose, for example, silicon nitride layers are used because of the hydrophobic properties thereof. It is also known to cover semiconductor devices with a layer of polyimide so as to protect them against radiation, notably against alpha-radiation. In the article "Polyimide Adhesion", by R.G. Narechania et al. in J. Electrochem. Soc. 132 (11), pp. 2700-2705 (1985) a method is described to improve the bonding of a polyimide to a surface coated with silicon nitride while using 3-aminopropyl-triethoxysilane. The mechanism according to which the bonding agent acts is described by H.G. Linde in J. Polymer. Sci., Polymer Chem. Ed., 20, pp. 1031-1041 (1982). According to that mechanism the amino group of the bonding agent reacts with a free carboxyl group of the polyimide.

United States Patent 4,330,569 discloses the use of hexamethyldisilazane as an adhesion promotor for photoresists on silicon nitride surfaces. The surface is pretreated with an oxygen plasma.

European Patent Application EP-A-0107240 discloses the use of aminosilanes for the adhesion promotion of photoresists on several surfaces.

If it is desirable to make electrical connections with contact pads on the surface of the semiconductor device it is efficacious to use a photosensitive polyamide in which apertures can be etched in the form of a pattern, after which the polyamide is converted to polyimide. A polyamide suitable for that purpose does not comprise any free carboxyl groups but, for example, acrylate ester groups which can produce the formation of a three-dimensional polymer network under the influence of radiation as a result of which the exposed parts of the polyamide become insoluble. For use a photosensitive polyamide glycidoxy propyl trimethoxysilane is generally used as a bonding agent because it is known that a glycidoxy group can react with an acrylate ester group. In experiments which have led to the present invention, however, it was established that the bonding of the photosensitive polyamide to silicon nitride is unsatisfactory when glycidoxypropyl trimethoxysilane is used as a bonding agent. The result of unsatisfactory bonding is that undercutting occurs during the development of the polyamide as a result of which the resulting pattern definition is unacceptably bad.

It is the object of the invention to provide a method of covering a device, for example a semiconductor device, by means of which method a readily bonding polyamide layer can be provided on a silicon nitride layer so that readily defined apertures can be etched in the polyamide layer, after which the polyamide is converted to polyimide.

According to the invention this object is achieved by means of a method as described in the opening paragraph which is characterized in that a silicon nitride layer is provided on a substrate and is made hydrophilic, after which a bonding agent is provided on the silicon nitride layer and a layer of a photosensitive polyamide is then provided, in which apertures are etched in patterns so as to give access to contact pads for electrical connections, the bonding agent being a trialkoxysilane compound which comprises a primary amino group, after which the polyamide is converted to polyimide.

The alkoxy groups in the trialkoxysilane compound preferably comprise small, preferably unbranched, alkyl groups, for example, methyl groups and ethyl groups. When providing the bonding agent the trialkoxysilane compound is hydrolised, the alkoxy groups being split off, and Si-O-Si bonds with the silicon nitride surface are formed. The bonding of the bonding agent with the photosensitive polyamide cannot take place in the usual manner with free carboxyl groups because these are not present in the photosensitive polyamide. The supposed mechanism on which the method according to the invention is based is a Michael addition of the amino group of the bonding agent to an unsaturated bond of an acrylate ester group of the polyamide.

The bonding between the bonding agent and the polyamide is considerably intensified if the bonding agent comprises in addition to the primary amino group at least one secondary amino group. The suggested mechanism for this improvement is as follows. An amino group which is at some distance from the Si-O group in the molecule chain of the silane compound can to a certain extent be immobilised by an attractive interaction with the Si-O group or with the surface to which the silane compound is bonded. A ring structure is formed and the amino group is not available for a bonding with the polyimide. If the distance between the amino group and the Si-O group is so small that ring formation does not occur, the mobility of the amino group on the other hand is small and the possibility of a bond with the polyimide is also small. As a result of the choice of a silane compound with one or more secondary amino groups the phenomenon occurs that the Si-O groups are screened therewith. The primary amino group remains free for a chemical bond with a suitable group of the polyamide. It may be noted that silane compounds having more than one primary amino group could be used in principle but these are not readily available.

In a preferred embodiment of the method according to the invention the bonding agent is N-(2-aminoethyl)-3-aminopropyltrialkoxy-silane, the alkoxy groups being selected from methoxy groups and ethoxy groups.

In a suitable embodiment of the method in accordance with the invention the silicon nitride layer is made hydrophilic by means of a treatment with ozone and exposure to UV light.

The invention will now be described in greater detail with reference to examples and with reference to a drawing, in which

Fig. 1 is a diagrammatic sectional view of a device according to the invention,

Figs. 2 and 3 show structural formulae of alternative silane compounds suitable for use in the method according to the invention,

Fig. 4 shows the structural formula of a photosensitive polyamide suitable for use in the method according to the invention, and

Fig. 5 shows diagrammatically the suggested reaction mechanism of the method according to the invention.

Example 1.

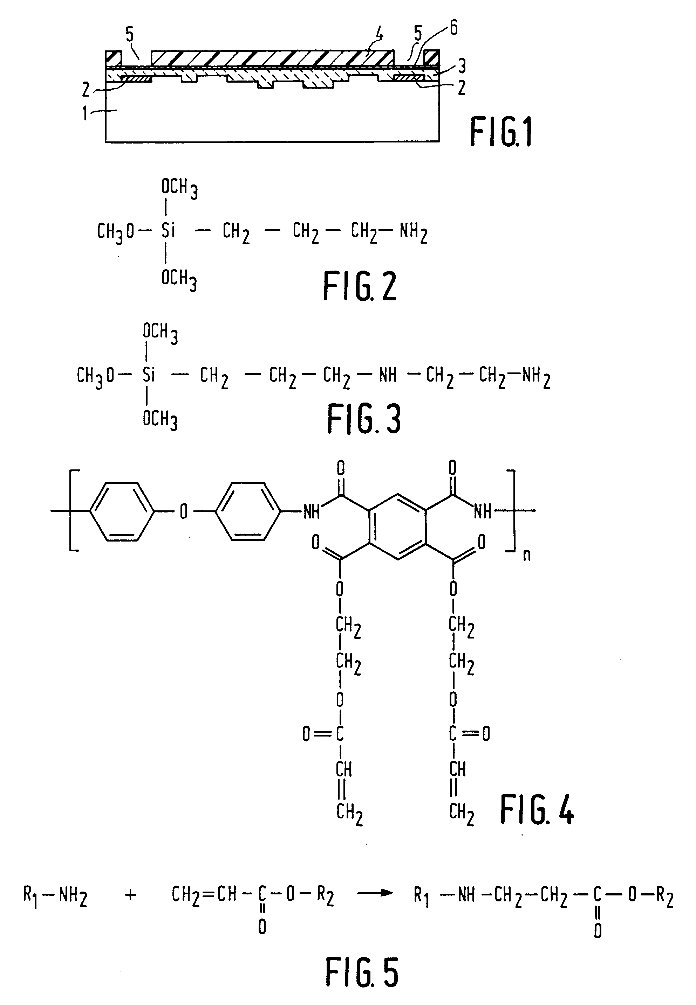

Fig. 1 shows a semiconductor device 1 having contact pads 2 for electrical connections. The semiconductor device 1 is covered with a layer 3 of silicon nitride, which layer has been provided, for example, by means of chemical vapour deposition. The surface of the silicon nitride layer 3 is made hydrophilic by a treatment with UV/ozone for 5 minutes.

A bonding agent is then provided by placing the semiconductor device 1 in a solution of 1% by weight of 3-aminopropyl-trimethoxysilane (see Fig. 2) in toluene at 100°C for 1 hour. The bonding agent is shown as a layer 6 in Figure 1. This Figure is not to scale. Layer 6 is only about one molecule thick.

A layer 4 of a photosensitive polyamide is then provided in a thickness of 65 nm by spinning a solution of the polyamide for 20 seconds at a rate of 680 rpm on the surface. The photosensitive polyamide is dried at 60°C for 6 hours. The polyamide used is a compound according to the structural formula which is shown in fig. 4 having a number-averaged molecular weight of approximately 10,000 and is provided from a solution in a 1:1 mixture of N-methyl-2-pyrrolidone and cyclopentanone with such a concentration that the viscosity is 2.35 Pa.s. The photosensitive initiator 2,2-dimethoxy-2-phenyl-acetophenone is added to the solution in a quantity which is 2% by weight of the quantity of polyamide.

The polyamide layer 4 is exposed to UV light having a wavelength of 300 to 400 nm, for example, by means of an electrodeless mercury lamp, via a mask (not shown in the figure) for 8 minutes. The non-exposed parts of the polyamide layer are dissolved by means of cyclopentanone, apertures 5 being formed in the polyamide layer 4, which apertures are suitable to manufacture electrical connections with the underlying contact pads 2. For this purpose the silicon nitride may be removed locally, if desired by means of a suitable etching treatment.

Fig. 5 shows the suggested reaction mechanism according to which the bonding agent works. $R_1$ represents the molecular radical of the silane molecule which is coupled to the silicon nitride surface via Si-O-Si bonds, $R_2$ is the molecular radical of the polyamide molecule. The polyamide is converted to polyimide by a thermal treatment during 5 hours at temperatures up to 300°C.

Example 2.

The method was carried out as described in Example 1, but this time with the use of N-(2-aminoethyl)-3-aminopropyl-trimethoxysilane (see Fig. 3) as the bonding agent.

Example 3.

The method as carried out as described in Example 2 in which the bonding agent was provided by placing the semiconductor device in a solution of 1% by weight of N-(2-aminoethyl)-3-aminopropyl-trimethoxysilane in water for 2 minutes and then rinsing with water.

A further improvement can be obtained by subsequently storing the semiconductor device at a temperature of 125°C for 30 minutes, but this step is not strictly necessary.

Example 4.

The method was carried out as described in example 2 in which the bonding agent was provided by placing the semiconductor device in the vapour of N-(2-aminomethyl)-3-aminopropyl-trimethoxysilane at a pressure of approximately 100 Pa for 1 hour.

The semiconductor devices obtained by means of the methods according to the above examples, in particular according to examples 2 to 4, are characterized by a particularly good bonding between the silicon nitride layer and the polyamide layer as a result of which during etching apertures in the polyamide layer no undercutting occurred and a good pattern definition of the apertures was obtained.

## Claims

1. A method of manufacturing a device at least one surface of which is covered with a first layer of silicon nitride and with a second layer of a polyimide in which a bonding agent is used at the interface of the two layers, characterized in that a silicon nitride layer is provided on a substrate and is made hydrophilic, after which a bonding agent is provided on the silicon nitride and a layer of a photosensitive polyamide is then provided, in which apertures are etched in patterns so as to give access to contact pads for electrical connections, the bonding agent being a trialkoxysilane compound which comprises a primary amino group, after which the polyamide is converted to polyimide.

2. A method as claimed in Claim 1, characterized in that the bonding agent comprises in addition at least one secondary amino group.

3. A method as claimed in Claim 2, characterized in that the bonding agent is N-(2-aminoethyl)-3-aminopropyltrialkoxysilane, the alkoxy groups being selected from methoxy groups and ethoxy groups.

4. A method as claimed in Claim 1, characterized in that the silicon nitride layer is made hydrophilic by means of a treatment with ozone and exposure to UV light.

## Revendications

1. Procédé pour la fabrication d'un dispositif dont au moins une surface est recouverte d'une première couche en nitrure de silicium et d'une deuxième couche en un polyimide, un adhésif étant utilisé à l'interface des deux couches, caractérisé en ce qu'une couche en nitrure de silicium est appliquée sur un substrat et est rendue hydrophile, après quoi un adhésif est appliqué sur la couche en nitrure de silicium et une couche en polyamide photosensible est ensuite appliquée, couche dans laquelle sont réalisées par décapage des ouvertures sous forme de configurations afin de permettre l'accès aux faces de contact pour les connexions électriques, l'adhésif étant un composé de trialkoxysilane qui contient un groupe amino primaire, après quoi la polyamide est transformée en polyimide.

2. Procédé selon la revendication 1, caractérisé en ce que l'adhésif contient en outre au moins un groupe amino secondaire.

3. Procédé selon la revendication 2, caractérisé en ce que l'adhésif est le N-(2-aminoéthyl)-3-aminopropyltrialkoxysilane, les groupes alkoxy étant choisis entre les groupes méthoxy et les groupes éthoxy.

4. Procédé selon la revendication 1, caractérisé en ce que la couche en nitrure de silicium est rendue hydrophile par un traitement avec de l'ozone et exposition à de la lumière ultra-violette.

## Patentansprüche

1. Verfahren zum Herstellen einer Anordnung, von der mindestens eine Oberfläche mit einer ersten Schicht aus Siliziumnitrid und mit einer zweiten Schicht aus einem Polyimid bedeckt ist, wobei an der Grenzfläche der beiden Schichten ein Haftvermittler verwendet ist, dadurch gekennzeichnet, daß auf einem Träger eine Siliziumnitridschicht vorgesehen wird, die hydrophil gemacht wird, wonach auf der Siliziumnitridschicht ein Haftvermittler und danach eine Schicht aus einem photoempfindlichen Polyamid vorgesehen wird, in der Öffnungen mustermäßig eingeätzt werden, wodurch Kontaktflächen für elektrische Anschlüße frei gemacht werden können, wobei der Haftvermittler eine Trialkoxysilanverbindung mit einer primären Aminogruppe ist, wonach das Polyamid in Polyimid umgewandelt wird.

2. Verfahren nach Anspruch 1, dadurch gekennzeichnet, daß der Haftvermittler außerdem mindestens eine sekundäre Aminogruppe aufweist.

3. Verfahren nach Anspruch 2, dadurch gekennzeichnet, daß der Haftvermittler N-(2-Aminoäthyl)-3-Aminopropyl-Trialkoxysilan ist, wobei die Alkoxygruppen aus Methoxy- und Äthoxygruppen gewählt worden sind.

4. Verfahren nach Anspruch 1, dadurch gekennzeichnet, daß die Siliziumnitridschicht mittels einer Ozon-Behandlung und durch UV-Bestrahlung hydrophil gemacht wird.

FIG.1

$$CH_3O - \underset{\underset{OCH_3}{|}}{\overset{\overset{OCH_3}{|}}{Si}} - CH_2 - CH_2 - CH_2 - NH_2$$

FIG. 2

$$CH_3O - \underset{\underset{OCH_3}{|}}{\overset{\overset{OCH_3}{|}}{Si}} - CH_2 - CH_2 - CH_2 - NH - CH_2 - CH_2 - NH_2$$

FIG. 3

FIG. 4

$$R_1 - NH_2 \quad + \quad CH_2 = CH - \underset{\underset{O}{\|}}{C} - O - R_2 \quad \longrightarrow \quad R_1 - NH - CH_2 - CH_2 - \underset{\underset{O}{\|}}{C} - O - R_2$$

FIG. 5